# EUROPEAN PATENT APPLICATION

(11) **EP 4 310 906 A1**
(43) Date of publication of application: **24.01.2024**
(21) Application number: 22186559.5
(22) Date of filing: 22.07.2022
(51) Int. Cl.: H01L 23/495

(54) **SEMICONDUCTOR PACKAGE AND METHOD**

(71) Applicant: Infineon Technologies Austria AG, 9500 Villach (AT)
(72) Inventor: BEHRENS, Thomas, 93173 Wenzenbach (DE); HEITZER, Ludwig, 94350 Falkenfels (DE); HOEGLAUER, Josef, 85551 Heimstetten (DE); IRRGANG, Christian, 93161 Sinzing (DE); MEYER, Thorsten, 93053 Regensburg (DE); SCHARF, Thorsten, 93137 Lappersdorf (DE); ZUDOCK, Frank, 93161 Sinzing (DE)
(74) Representative: JENSEN & SON

(57) **Abstract**

In an embodiment, a semiconductor package comprises a lower surface comprising a low voltage contact pad, a high voltage contact pad, an output contact pad and at least one control contact pad. The semiconductor package further comprises a halfbridge circuit comprising a first transistor device having a first major surface and a second transistor device having a first major surface, the first and second transistor devices being electrically coupled in series at an output node and a control device that is electrically coupled to the first transistor device and the second transistor device. The first major surface of the first transistor device and of the second transistor device are arranged substantially perpendicularly to the lower surface of the semiconductor package.

## Description

### BACKGROUND

A semiconductor package may include one or more semiconductor devices in a housing. The package may include a substrate or a leadframe on which the semiconductor device or devices are mounted and outer contacts which are used to mount the semiconductor package on a redistribution board such as a printed circuit board. The package also includes internal electrical connections from the semiconductor device to the substrate or leadframe. The housing may be formed by a plastic molding compound which covers the semiconductor device and the internal electrical connections.

Published US patent application US 2004/0212057 A1 discloses a semiconductor component including a housing and at least two semiconductor chips arranged in the housing.

Semiconductor packages, which include increased functionality and which occupy a smaller area when mounted on a higher-level board, such as a circuit board, are desirable.

### SUMMARY

According to the invention, a semiconductor package is provided that comprises a lower surface comprising a low voltage contact pad, a high voltage contact pad, an output contact pad, and at least one control contact pad. The semiconductor package further comprises at least one half-bridge circuit comprising a first transistor device having a first major surface and a second transistor device having a first major surface, the first and second transistor devices being electrically coupled in series at an output node. The semiconductor package also comprises at least one control device that is electrically coupled to the first transistor device and the second transistor device. The first major surface of the first transistor device and the first major surface of the second transistor device are arranged substantially perpendicularly to the lower surface of the semiconductor package.

The semiconductor package includes a power stage including a half bridge circuit and one or more control devices. The control device may comprise gate driver circuitry for driving the gates of the first and second transistor device. The control device is electrically connected to the gates of the first and second transistor device. One or more of the control pads is electrically connected to the gate driver circuitry.

In some embodiments, the control device also includes circuitry for providing additional auxiliary functions, for example for source sensing. In these embodiments, one or more of the control pads provides an auxiliary contact pad that is electrically connected to the auxiliary circuitry.

In some embodiments, a first control device is provided that comprises gate driver circuitry and can be referred to as a gate driver and a second control device is provided that comprises control circuitry.

The semiconductor package is suitable for vertical mounting as the lower surface of the package, which comprises the low voltage contact pad, the high voltage contact pad, the output contact pad and the at least one control contact pad, is arranged substantially perpendicularly to the first major surface of each of the first and second transistor device. The low voltage contact pad, the high voltage contact pad, the output contact pad, and the at least one control contact pad provide the outer contacts of the semiconductor package that enable the package to be mounted on a higher-level circuit board, e.g. a printed circuit board, such that the first major surfaces of the first and second transistor devices are arranged in perpendicularly, i.e. in a vertical orientation, with respect to the major surface of the higher level circuit board. This reduces the area on the board which is occupied by the semiconductor package. In other words, the package has a smaller footprint.

The low voltage contact pad, the high voltage contact pad, the output contact pad, and the at least one control contact pad are substantially coplanar with one another and may each include a solderable outermost surface that is wettable by soft solder. The semiconductor package may be referred to as a vertical package. The vertical mounting arrangement is useful as the package requires less area on the circuit board compared to a package in which the first major surface of the transistor devices are arranged parallel to the lower surface of the package, which includes the contact areas, and first major surface of the circuit board. Thus, a semiconductor package is provided which includes a power stage and increased functionality and which occupies a smaller area on the higher-level circuit board due to the vertical mounting orientation.

In some embodiments, the control device comprises a first major surface that is arranged substantially perpendicularly to the lower surface of the semiconductor package.

In some embodiments, the semiconductor package further comprises first, second and third leads. The leads may each have the form of a substantially planar sheet. The leads may also be referred to as clips. The first lead that an inner surface that extends substantially perpendicularly to the lower surface and a lower side face that forms the low voltage contact pad. The second lead has an inner surface extends substantially perpendicularly to the lower surface and a lower side face that provides the high voltage contact pad. The third lead has a first inner surface and a second inner surface opposing the first inner surface and the lower side face extends between the first and second inner surfaces. The lower side face of the third leads provides the output pad of the semiconductor package and is arranged in the lower surface of the semiconductor package laterally between the low voltage contact pad and the high voltage contact pad.

The first transistor device is mounted on the first inner surface and the second transistor device is mounted on the second inner surface of the third lead so that the third lead provides the output node. The first major surface of the respective first and second transistor device are arranged substantially parallel to one another and in a stack. The first lead is arranged at a first package side face and the second lead is arranged at a second package side face that opposes the first package side face.

The first lead has an outer surface that opposes the inner surface and the lower side face extends between the inner and outer surface. Similarly, the second lead has an outer surface that opposes the inner surface and the lower side face extends between the inner and outer surface. The outer surface of the first and second lead may be at least partially exposed from a mold compound providing the semiconductor housing and may be used to provide cooling from both vertically arranged sides of the semiconductor package. Additional heat sinks or fins may be attached to one or more of the outer surfaces.

In addition to the first and second transistor devices and the control device, the inner surfaces of the first and second lead and the first and second inner surface of the third lead are covered by the mold compound and hence denoted inner surfaces.

The inner surface and out surface of the first and second lead and the first and second inner surfaces of the third lead are major surfaces and the lower side face of the respective lead is a minor surface as its area is less than the area of the major surface of the respective lead.

In this arrangement the first and second transistor devices are arranged on opposing surfaces of the third lead. The first and second leads are arranged at opposing sides faces of the package and the third lead is arranged between the first and second leads towards the centre of the package. The first lead is arranged on the first transistor device and the second lead on the second transistor device. The first, second and third leads and the first and second transistor devices can be considered to be arranged in a stack with the stacking direction extending parallel to the lower surface of the semiconductor package.

In some embodiments, the at least one control contact pad is arranged in a common plane with the low voltage contact pad, the plane extending substantially perpendicularly to the lower surface of the package and parallel to the first major surface of the first transistor device. The at least one contact pad and the low voltage contact pad are arranged on the same side of the output contact pad, i.e. laterally adjacent the first inner surface of the third lead.

In some embodiments, the at least one control contact pad is arranged in a common plane with the high voltage contact pad, the plane extending substantially perpendicularly to the lower surface of the package and parallel to the first major surface of the first transistor device. The at least one contact pad and the high voltage contact pad are arranged on the same side of the output contact pad, i.e. laterally adjacent the second inner surface of the third lead.

In some embodiments, the at least one control contact pad is arranged in a common plane with the output contact pad. The at least one contact pad may form a row with the output contact pad.

In some embodiments, two or more control contact pads are provided and at least one of the control contact pads is arranged in a common plane, e.g. forms a first row, with the high voltage contact pad, the plane extending substantially perpendicularly to the lower surface of the package and parallel to the first major surface of the first transistor device, and another at least one of the control contact pads is arranged in a common plane, e.g. forms a second row, with the output contact pad, the plane extending substantially perpendicularly to the lower surface of the package and parallel to the first major surface of the first transistor device. The first and second rows are laterally spaced part from one another and extend substantially parallel to one another.

In some embodiments, the low voltage contact pad, the high voltage contact pad and the output contact pad are each elongate and extend substantially parallel to one another. The low voltage contact pad, the high voltage contact pad and the output contact pad may each have a strip-like form, for example a rectangular shape.

In some embodiments, the low voltage contact pad, the high voltage contact pad and the output contact pad are each elongate, a strip-like form such as a rectangular shape, and extend substantially parallel to one another over the entire breadth of the lower surface of the semiconductor package.

In some embodiments, the low voltage contact pad, the high voltage contact pad and the output contact pad are each elongate, e.g. a strip-like form such as a rectangular shape, and extend substantially parallel to one another and one or more of the low voltage contact pad, the high voltage contact pad and the output contact pad extend over only a portion of the lower surface of the semiconductor package, for example over only a portion of the breadth of the lower surface.

In some embodiments, the low voltage contact pad, the high voltage contact pad and the output contact pad each have a width that is less than or equal to a thickness of the first lead, the second lead and the third lead, respectively.

In some embodiments, the first transistor device comprises a first power pad on the first major surface and a second power pad on a second major surface opposing the first major surface and the second transistor device comprises a first power pad on the first major surface and a second power pad a second major surface opposing the first major surface.

In some embodiments, the second power pad of the first transistor device is mounted on the first inner surface of the third lead and the first power pad of the second transistor device is arranged on the second inner surface of the third lead. The first lead comprises an inner surface attached to the first power pad of the first transistor device and the second lead comprises an inner surface attached to the second power pad of the second transistor device.

The first power pad of the first transistor device may be a source pad and the second power pad of the first transistor device may be a drain pad. The first power pad of the second transistor device may be a source pad and the second power pad of the second transistor device may be a drain pad. The drain pad of the first transistor device is mounted on the first inner surface of the third lead and the source pad of the second transistor device is mounted on the second inner surface of the third lead. Thus, the third lead electrically connects the source pad of the first transistor device to the drain pad of the second transistor device and forms the node of the half bridge circuit.

In some embodiments, the third lead comprises a recess in which the second transistor device is arranged. This arrangement may be used to reduce the width of the semiconductor package.

Each control pad may be provided by a lower side face of a metallic block or lead, whereby the lower side face of the metallic block or lead extends substantially perpendicularly to an inner surface of the block or lead that extends substantially parallel to the inner surface of the first lead and/or the first and second inner surfaces of the third lead.

In some embodiments, the first transistor device further comprises a first gate pad on the second major surface and the second transistor device further comprises a second gate pad on the second major surface. In this embodiment, the first gate pad is arranged laterally adjacent the drain pad of the first transistor device and the second gate pad is arranged laterally adjacent the drain pad of the second transistor device. As used herein the gate pad refers to the portion of the metallization structure arranged on the first and/or second major surface of the transistor device, and may also be called a terminal.

The first gate pad is arranged on the opposing side of the first transistor device to the gate electrodes of the transistor structure which are formed on or in the first major surface. The second gate pad is arranged on the opposing side of the second transistor device to the gate electrodes of the transistor structure which are formed on or in the first major surface.

In some embodiments, the control device is mounted on the first lead and laterally adjacent and spaced apart from the first transistor device. This arrangement may be used if the first lead is at ground potential, for example.

In some embodiments the control device is electrically connected to the first gate pad, the second gate pad and the control pads by additional connectors such as bond wires.

In embodiments, in which the semiconductor package includes two control devices, the two control devices may be mounted laterally adjacent one another on the first lead.

In some embodiments, the first transistor device further comprises a first gate pad on the first major surface and the second transistor device further comprises a second gate pad on the second major surface. In this embodiment, the first gate pad is arranged laterally adjacent the source pad of the first transistor device and the second gate pad is arranged laterally adjacent the drain pad of the second transistor device.

In some embodiments, the control device is electrically connected to the first gate pad and to the second gate pad by a connector, such as a bond wire. In some embodiments, the first and/or second transistor device further comprises one or more auxiliary functions, for example source sensing. In these embodiments, the transistor device further comprises one or more auxiliary pads. The auxiliary pad(s) may be arranged laterally adjacent to the gate pad. The auxiliary pad(s) may be electrically connected to the control device by a connector such as a bond wire.

In some embodiments, the first lead is provided by a leadframe comprising a first portion comprising electrically insulating material on which conductive traces and one or more of the control pads are formed and a second conductive portion formed of a metal or alloy. The second portion may have a thickness that corresponds to the thickness of the electrically insulating material and therefore provides a conductive connection between the two opposing sides of the leadframe. The second metal portion provides one of the leads, for example the third lead. The leadframe may also be described as a routable leadframe or a redistribution substrate. The control device is mounted on the first portion including the electrically insulating material. This may be used for embodiments in which the first transistor device further comprises a first gate pad on the first major surface and the second transistor device comprises a second gate pad on the second major surface. The first and second transistor devices are mounted on and electrically connected to opposing sides of the conductive portion.

In some embodiments, the first gate pad and the second gate pad are electrically connected to conductive traces of the leadframe by an additional connector such as a bond wire and the control device is connected to the control pads and/or conductive traces by an additional connector such as a bond wire.

In embodiments, in which the semiconductor package includes two control devices and the first lead is provided by a leadframe, the two control devices may be mounted laterally adjacent one another on the first portion of the leadframe that comprises the electrically insulating material.

In some embodiments, the semiconductor package further comprises a mold compound. In some embodiments, the control device, the bond wires, the first and second transistor devices, inner surfaces of the first and second leads and first and second inner surfaces of the third lead are covered by the mold compound. The outer surface of the first lead may remain at least partially uncovered by the mold compound and the outer surface of the second lead be entirely covered by the mold compound. In some embodiments the outer surface of the both first and second leads remains at least partially uncovered by the mold compound. The low voltage contact pad, the high voltage contact pad and the output contact pad are uncovered by the mold compound.

In some embodiments, the semiconductor package comprises two half bridge circuits; a first half bridge circuit and a second half bridge circuit that are electrically coupled to form a full bridge or H circuit.

In some embodiments, each of the first and second half bridge circuits comprises a first and a second transistor device according to any one of the embodiments described herein. For example, the first transistor devices of each of the two half bridge circuits are arranged laterally adjacent one another and be mounted on and electrically coupled to the same lead or substrate that provides the low voltage lead. Similarly, the second transistor devices of each of the two half bridge circuits are arranged laterally adjacent one another and be mounted on and electrically coupled to the same lead or substrate that provides the high voltage lead. Each of the first and second half bridge circuits has a separate output lead so that the first and second transistor device of the first half bridge circuit are arranged on opposing sides of a first output lead, e.g. the third lead described above, and the first and second transistor device of the second half bridge circuit are arranged on opposing sides of a second output lead. The second output lead may have the same form as the third lead according to any one of the embodiments described herein.

The invention also provides methods of fabricating a semiconductor package including a power stage. In one method, the method comprises providing a first transistor device comprising a first power pad on a first major surface and a second power pad and a first gate pad on a second major surface that opposes the first major surface and providing a second transistor device comprising a first power pad on a first major surface and a second power pad and a second gate pad on a second major surface that opposes the first major surface. A control device and the first power pad of the first transistor device are attached to an inner surface of a first lead. A first inner surface of a third lead is attached to the second power pad of the first transistor device. The first power pad of the second transistor device is attached to a second inner surface of the third lead, the second inner surface opposing the first inner surface and a second lead is attached to the second power pad of the second transistor device. The first gate pad and the second gate pad are electrically connected to the control device and the control device is electrically connected to at least one control contact pad that is integrally formed in the first lead. A mold compound is applied such that it that covers the inner surfaces of the first, second and third leads, the first and transistor devices and the bond wires. The first lead is patterned or structured to separate the control pads. The at least one control contact pad, and side faces of the first, second and third leads that are arranged substantially perpendicularly to the respective inner surface are arranged in a common plane that is substantially perpendicular to the first major surface of the first transistor device.

In this embodiment, the semiconductor package is built up in a stack in a single stacking direction. In some embodiments, the semiconductor package is built up in a stack in a single stacking direction with the first lead acting as the base or substrate. The methods may be carried out in the order given above.

In some embodiments, the first gate pad and the second gate pad are electrically connected to the control device by a further connector such as a bond wire and the control device is electrically connected to at least one control contact pad that is integrally formed in the first lead by further connector such as a bond wire. If one or both of the first and second transistor devices includes an auxiliary pad, for example, for source sensing, the auxiliary pad is electrically connected to the control device or one of the control contact pads by an additional connector such as a bond wire.

The first power pad of the first transistor device may be attached to an inner surface of a first lead, the first inner surface of the third lead to the second power pad of the first transistor device, the first power pad of the second transistor device to the second inner surface of the third lead and the second lead to the second power pad of the second transistor device using a solder connection. A solder reflow process may be used. Alternatively, one or more of the solder connections may be replaced by glue, e.g. electrically conductive epoxy, or a sintering process or diffusion solder.

In an alternative method of fabricating a semiconductor package including a power stage, the method comprises providing a first transistor device comprising a first power pad and a first gate pad on a first major surface and a second power pad on a second major surface that opposes the first major surface and providing a second transistor device comprising a first power pad on a first major surface and a second power pad and a second gate pad on a second major surface that opposes the first major surface. The second power pad of the first transistor device is attached to a third lead, the third lead being formed in a first inner surface of a leadframe comprising electrically insulating material on which conductive traces and at least one control pad are formed. An inner surface of a first lead is attached to the first power pad of the first transistor device. The first gate pad is electrically connected to a first conductive trace on the first inner surface of the leadframe. The first power pad of the second transistor device is attached to the third lead arranged in a second inner surface of the leadframe, the second inner surface opposing the first inner surface and a second lead is attached to the second power pad of the second transistor device. The second gate pad is electrically connected to a second conductive trace on the second inner surface of the leadframe and the control device is electrically connecting to at least one third conductive trace, the at least one third conductive trace being electrically connected to a control pad. A mold compound is applied that covers the inner surfaces of the first, second and third leads, the first and transistor devices and the bond wires. The at least one control contact pads, and side faces of the first, second and third leads that are arranged substantially perpendicularly to the respective inner surface are arranged in a common plane that is substantially perpendicular to the first major surface of the first transistor device.

In this embodiment, the third lead is provided as a routable leadframe and the routable leadframe is inverted to enable the first and second transistor devices to be mounted on the opposing first and second inner surfaces of the conductive portion of the leadframe. The method may be carried out in the order given above.

In some embodiments, the first gate pad and the second gate pad are electrically connected to the control device by a further connector such as a bond wire and the control device is electrically connected to at least one control contact pad that is integrally formed in the first lead by further connector such as a bond wire. If one or both of the first and second transistor devices includes an auxiliary pad, for example, for source sensing, the auxiliary pad is electrically connected to the control device or one of the control contact pads by an additional connector such as a bond wire.

The second power pad of the first transistor device may be attached the third lead, the inner surface of a first lead to the first power pad of the first transistor device, the first power pad of the second transistor device to the third lead and the second lead is attached to the second power pad of the second transistor device by a solder connection. A solder reflow process may be used. Alternatively, one or more of the solder connections may be replaced by glue, e.g. electrically conductive epoxy, or a sintering process or diffusion solder.

The first and second gate pad and the control pad may be electrically connected to the respective conductive trace by an additional connector such as a bond wire.

Both methods may be carried out for a plurality of packages at substantially the same time to form a panel. The panel is then diced or singulated to form individual packages. The panel may be singulated such that the outer contact areas are formed in the cut surface.

For example, a plurality of first leads may be provided by a first metallic sheet comprising a plurality of component positions, each component position providing the first lead of one semiconductor package. Similarly, a plurality of second leads may be provided by a second metallic sheet comprising a plurality of component positions, each component position providing the second lead of one semiconductor package and a plurality of third leads may be provided by a third metallic sheet comprising a plurality of component positions, each component position providing the third lead of one semiconductor package. A plurality of first transistor devices is attached to the first metallic sheet, one in each component position, the third metallic sheet attached to the plurality of first transistor devices, a plurality of the second transistor devices attached to the third metallic sheet, one in each component position, and the second metallic sheet attached to the second transistor devices. A mold compound is then applied to form the panel and the panel diced by cutting between the component positions, thus exposing the side faces of individual ones of the first, second and third leads, which form the output pads in the lower surface of the package, enabling vertical mounting of the package onto a circuit board.

The control pads may be formed from protrusions of the first metallic sheet after the molding process, for example by etching the first metallic sheet, to separate the protrusions from the first metallic sheet. Alternatively, the control pads may be formed in a further leadframe strip having a plurality of component positions in which the control leads are held by tie bars in the leadframe strip. The leadframe strip is then arranged on the first or third metallic sheet and the tie bars are removed in the singulation process.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1, which includes figures 1A to 1H which illustrates views of a semiconductor package according to an embodiment.
Figure 2 illustrates a method for fabricating a semiconductor package according to an embodiment.
Figure 3, which includes figures 3A to 3F, illustrates views of a semiconductor device according to an embodiment.
Figure 4 illustrates a method for fabricating a semiconductor package according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A power stage includes a half bridge circuit and control chip, for example a gate driver chip, and may be used on customer boards for efficient power management. One application area for power stages is for processor units like CPUs or GPUs. The trend of higher integration and more cores in a processing unit leads to an increase in the number and/or size of the power stages which in turn leads to a need for more board space for power management. The distance between a CPU/GPU and the power stage also should desirably be minimized in order to remain efficient and avoid parasitics as well as unwanted power losses. These issues lead to design and routing challenges on the board.

The trend for higher functional integration and a higher power consumption of processing units is causing a need for better usage of board space. This could be achieved by providing a smaller footprint of the power stage. This enables closer placement of the power stage towards the processor. The invention proposes an arrangement of the power stages, which allows the vertical placement of a semiconductor package including a power stage on the user's board.

According to the invention, a package with a reduced area package footprint is provided whilst avoiding the limitations caused by the chip area of highside, lowside and driver devices of the power stage. The chips are stacked in a suitable way, to allow the vertical arrangement of the package on the user board assembly. In this way the package footprint on the board is minimized. The package can be called a Vertical Power Package (VPP).

The package may be assembled with classical horizontal chip assembly process steps, but all contact elements (e.g. leadframe, clips, substrates...) protrude to one or more package edges. The vertical assembly of the package is achieved by all clips and substrates or leadframes being accessible at lead frames least one package edge, i.e. in a sidewall of the package, which has an area that is less than the area of the larger major surfaces of the leadframe, clips and substrates. The vertical assembly of the package is carried out by a physical assembly of all the clips, leadframes and substrate substrates that are exposed in the side wall of the package to the customer board during board assembly.

This vertical arrangement of the package enables a reduction of the occupied board space, which allows the customer to place a higher number of power stages close to a CPU or GPU unit on the board. A reduced parasitic inductance is provided due to low distance between VIN and GND potential in the package. A low on resistance Ron is provided due to low electrical resistance between drain of the lowside switch and the source of the highside switch, which leads to an optimized current flow and improved current management. Thermal management is improved as the biggest surfaces of the package can be used for cooling instead for connecting the device. Additionally, a cooling fin/plate can be attached at the device's sidewalls, preferably with a TIM material (e.g. similar to a classical TO package cooling). Additional capacitors (e.g. a boot capacitor) can be placed on upper side of the package which allows an even higher integration level and minimized inductance.

The package may include a stack of three metallic sheets, e.g. copper sheets, or a routable leadframe in a stack with two metallic, e.g. copper, sheets. The connection pads of the device may be formed by singulation. With this singulation, the accessibility to all clips and substrates within the package for the customer board, additional devices or cooling features is achieved.

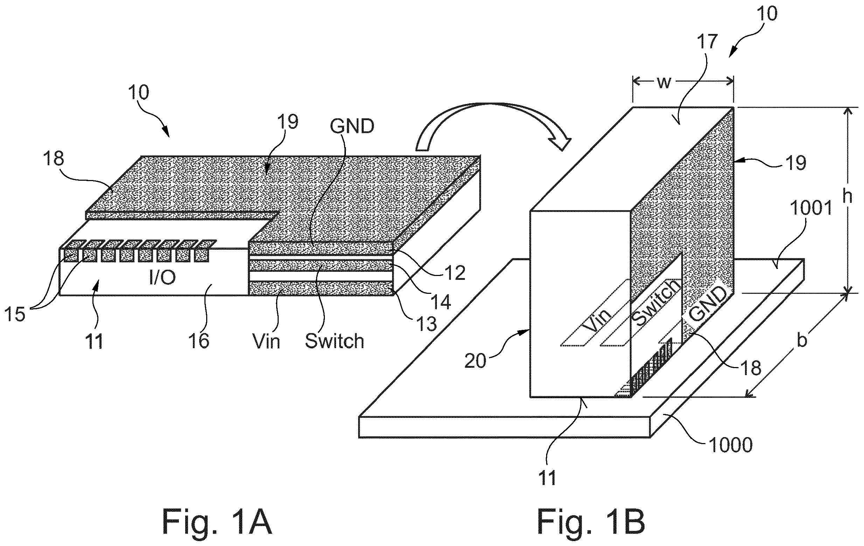

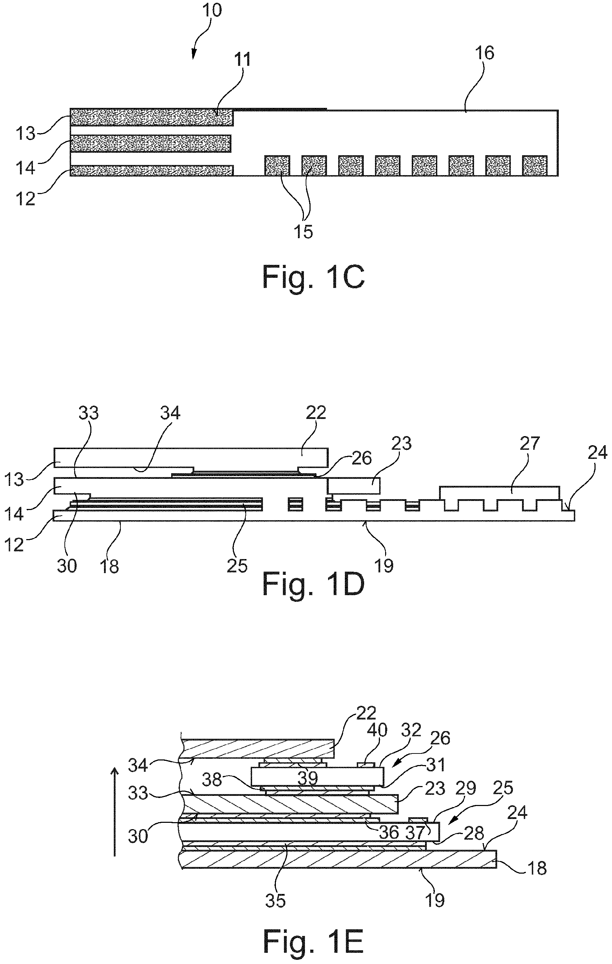

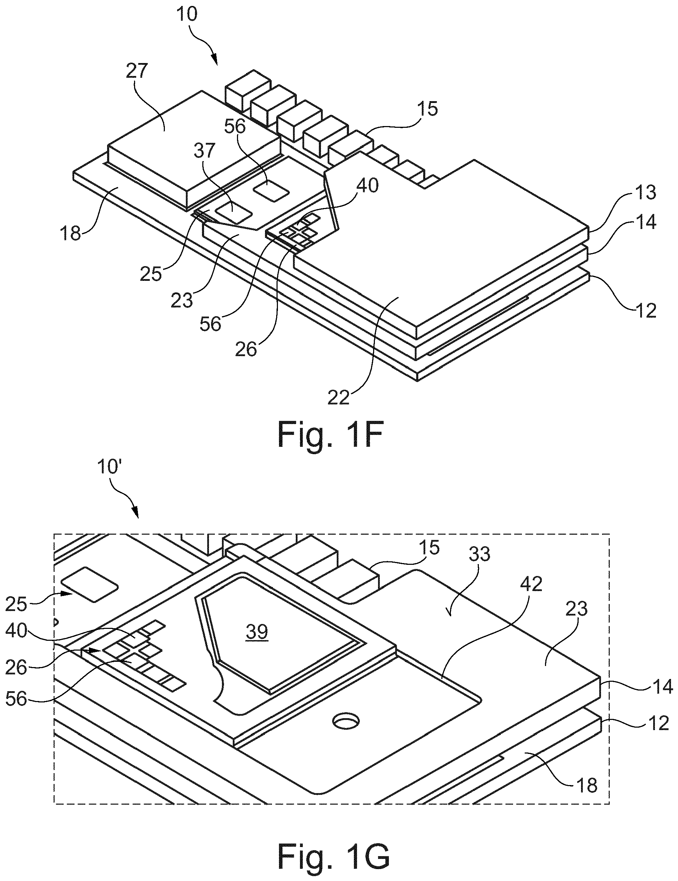

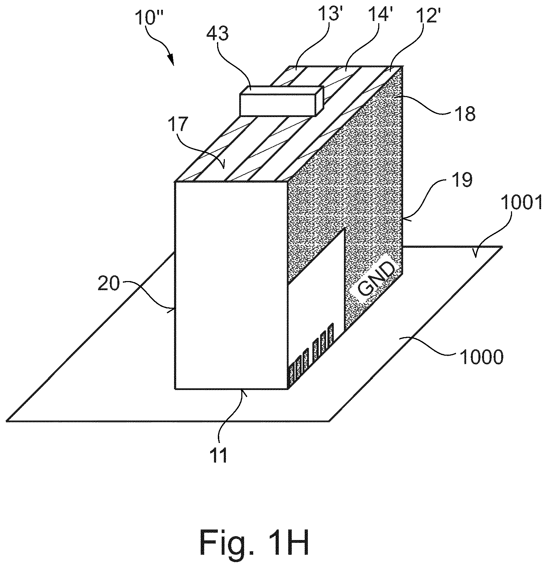

Figure 1, which includes figures 1A to 1H illustrates various views of a semiconductor package 10.

Figure 1A illustrates a perspective view of a semiconductor package 10 which has a substantially rectangular cuboid shape having a width, w, a breadth, b, and a height, whereby the width is less than the breadth and the height. The semiconductor package 10 has a lower surface 11 which provides the mounting surface of the package 10 and which has an area, defined by the width multiplied by the breadth. The area of the lower surface is less than the area of the opposing side faces 19, 20 of the package 10. Figure 1B illustrates a view of the semiconductor package 10 when mounted on a higher level circuit board 1000. The lower surface 11 of the semiconductor package 10 is mounted on the major surface 1001 the circuit board 1000 and can be considered to have a vertical arrangement.

As can be seen in figure 1A, the lower surface 11 comprises the outer contact pads of the semiconductor package 10 which are used to mount the package 10 on a higher level circuit board. The outer contact pads are substantially coplanar and exposed from a mold compound 16 which forms the package housing and include a low-voltage contact pad 12, a high-voltage contact pad 13, an output contact pad 14 and a plurality of control contact pads 15. In some embodiments, the outer contact pads are further substantially coplanar with the lower surface of the mold compound 16. In other embodiments, the outer contact pads protrude from the lower surface of the mold compound 16.

The low-voltage contact pad 12, the high-voltage contact pad 13 and the upper contact pad 14 each have an elongate strip-like structure and are rectangular. The low-voltage contact pad 12, the high-voltage contact pad 13 and the upper contact pad 14 are arranged with their longest dimension substantially parallel to one another and such that the output contact pad 14 is arranged laterally between and spaced apart by portions of the mold compound 16 from the low voltage contact pad 12 and the high-voltage contact pad 13. The low-voltage contact pad 12, the high-voltage contact pad 13 and the output contact pad 14 extend over only a portion of the lower surface 11. The control contacts pads 15 typically are smaller in size and may be substantially square. The plurality of control contact pads is arranged in a row having a length which is aligned with the longest direction of the low-voltage contact pad 14.

As can be seen in the perspective view of the semiconductor package 10 shown in figure 1A, the low-voltage contact pad 12 is formed by a side face of a first lead 18. The first lead 18 has opposing major surface and the side face providing the low voltage contact pad 12 extends substantially perpendicularly between the major surfaces. One major surface forms the outer surface 19 of the first lead 18 and is exposed from the mold compound 16 and positioned at a first package side 19 of the semiconductor package 10.

In the mounted position shown in Figure 1B, the lower surface 11 of the semiconductor package 10 is mounted on the major surface 1001 the circuit board 1000. The lower side face of the first lead 18 extends substantially parallel to the upper surface 1001 of the circuit board 1000 and the first lead 18 extends substantially perpendicularly from the major surface 1001 of the circuit board 1000. The semiconductor package 10 and can be considered to have a vertical mounting arrangement.

The lower surface 11 has a cross-sectional area which is smaller than the cross-sectional area of the first package side face 19 and the second packet side face 20 which opposes the first package side face 19. Therefore, the semiconductor package 10 occupies a smaller area on the circuit board 1000 in this vertical arrangement with the lower surface 11 on the mounted on the upper surface 1001 of the circuit board compared to an arrangement in which the first package side face 19 of the package 10 is mounted on the upper surface 1001 of the circuit board 1000.

Figure 1C illustrates a side view of the semiconductor package 10 including the mold compound 16 and figure 1D illustrates a side view of the semiconductor package 10 in which the mold compound 16 is not shown. Therefore, the semiconductor devices which are mounted within the semiconductor package 10 can be seen in the side view of figure 1D. Figure 1E illustrates an enlarged cross-sectional view of a portion of the semiconductor package.

The semiconductor package 10 comprises a half bridge circuit comprising a first transistor device 25 and a second transistor device 26, which are electrically coupled in series at an output node of the half bridge circuit and a control device 27.

In figure 1D, it can be seen that the high-voltage contact pad 13 is formed by a side face of a second lead 22 and the output contact pad 14 is formed by a side face of the third lead 23. The first, second and third leads 18, 22, 23 have a stacked arrangement with the third lead 23 being arranged between the first and second leads 18, 22. The first lead 18 has an inner surface 24 which opposes the outer surface 19 and which in the final package 10 is positioned within the mold compound 16. The first transistor device 25 is arranged on the inner surface 24 of the first lead 18, the third lead 23 is arranged on the first transistor device 25, the second transistor device 25 is arranged on the third lead 23 and the second lead 22 is arranged on the second transistor device 26. The second lead 22 has an inner surface 34 which extends substantially perpendicularly to the lower surface 11 of the semiconductor package. The second lead 22 has a side face that extends substantially perpendicularly to the inner surface 34 and which is arranged in the lower surface 11 of the package 10 and forms the high-voltage contact pad 13.

The third lead 23 has a first inner surface 30 and a second inner surface 33 which opposes the first inner surface 30. The first and second inner surfaces 30, 33 extend substantially perpendicularly to the lower surface 11 of the semiconductor package. The third lead 23 has a side face that extends substantially perpendicularly to the first and second inner surfaces 30, 33 and which is arranged in the lower surface 11 of the package 10 and forms the output contact pad 14.

The first transistor device 25 and the second transistor device 26 are both attached to the third lead 23 which provides an electrical connection between them and the output node of the half bridge circuit. The output node is accessed by way of the output pad 14 formed by the side face of the third lead 23 that is positioned in the lower surface 11 of the semiconductor package 10. The control device 27 is electrically connected to the first transistor device 25 and the second transistor device 26. The control device or chip 27 may include a gate driver circuitry for driving the gate of the first and second transistor devices 25, 26 and is electrically connected to the gates of the first and second transistor devices 25, 26.

Referring to the enlarged view of figure 1E, the first transistor device 25 includes a semiconductor substrate, for example a silicon substrate, and a first major surface 28 and a second major surface 29 which opposes the first major surface 28. The first major surface 28 as well as the second major surface 29 extend substantially perpendicularly to the lower surface 11 of the semiconductor package. The first major surface 28 of the first transistor device 25 is mounted on the inner surface 24 of the first lead 18. The opposing second major surface 29 of the first transistor device 25 is mounted on the first inner surface 30 of the third lead 23.

The second transistor device 26 also includes a semiconductor substrate, for example a silicon substrate, and a first major surface 31 and a second major surface 32 opposing the first major surface 31 and the first major surface 31 of the second transistor device 26 is mounted on the second inner surface 33 of the third lead 23 that opposes the first inner surface 30. The inner surface 34 of the second lead 22 is mounted on the second surface 32 of the second transistor device 26.

The first lead 18 and the second lead 22 are arranged on opposing sides of the semiconductor package 10 and each have an outer surface that opposes the inner surface that forms the opposing package side faces 19, 20. Since the low-voltage contact pad 12, the high-voltage pad 13 and the output contact pad 14 are formed by the lower side faces of the respective lead 18, 22, 23, they have each have a width which is less than or equal to a thickness of the respective lead.

The first transistor device 26 comprises a first power pad 35 which is arranged on the first major surface 29 and a second power pad 36 on second major surface 29. The first power pad 3 is electrically connected to the first lead 18 and the second power pad 26 is electrically connected to the third lead 23. In this embodiment, the first power pad 35 is the source pad and the second power pad 36 is the drain pad of the transistor device 25. The transistor device 25 also includes a first gate pad 37 arranged on the second surface 29 laterally adjacent to the drain pad 39. The first gate pad 37 is electrically connected to gate electrodes of the transistor structure formed in the semiconductor body of the transistor device 25 which are positioned adjacent the opposing first major surface 28 by a conductive via which is positioned within the transistor device 25 and not shown in the drawings.

The second transistor device 26 also has a first power pad 38 on its first major surface 31 and a second power pad 39 on its second major surface 33. The first power pad 38 is a source pad and the second power pad 39 that is arranged on the second major surface 32 is a drain pad. The source pad is electrically connected to the third lead 22 and drain pad 39 is electrically connected to the second lead 22. The second transistor device 26 further includes a second gate pad 40 which is arranged on the second side 32 adjacent the drain pad 39 and which is electrically connected to gate electrodes formed at the opposing first surface 31 by a conductive via positioned within the transistor device 26.

The first lead 18, first transistor device 25, the third lead 23, the second transistor device 26 and the second lead 22 can be considered to be arranged in a stack which has a stacking direction, indicating in figure 1E by the arrow, that is substantially parallel to the lower surface 11 of the package 100.

In some embodiments, the first and second transistor devices 25, 26 each have a drift path that extends substantially perpendicularly to the major surfaces of the device. Such a transistor device is often referred to as a vertical transistor device. In some embodiments, the transistor device is a MOSFET (Metal Oxide Semiconductor Field Effect Transistor) device, an insulated gate bipolar transistor (IGBT) device or a Bipolar Junction Transistor (BJT).

The pads or terminals of the transistor device are referred to herein as source, drain and gate. As used herein, these terms also encompass the functionally equivalent terminals of other types of transistor devices, such as an insulated gate bipolar transistor (IGBT). For example, as used herein, the term "source" encompasses not only a source of a MOSFET device and of a superjunction device but also an emitter of an insulator gate bipolar transistor (IGBT) device and an emitter of a Bipolar Junction Transistor (BJT) device, the term "drain" encompasses not only a drain of a MOSFET device or of a superjunction device but also a collector of an insulator gate bipolar transistor (IGBT) device and a collector of a BJT device, and the term "gate" encompasses not only a gate of a MOSFET device or of a superjunction device but also a gate of an insulator gate bipolar transistor (IGBT) device and a base of a BJT device.

Figure 1F illustrates a top perspective view of the semiconductor package 10 in which the first and transistor devices 25, 26, the control chip 27 as well as the three leads 18, 22 and 23 can be seen. In the top perspective view it can be seen that the third lead 23 which is arranged in the middle of the stack and provides the output pad 14 has a lateral extent which is less than the lateral extent of the first lead 18. The control device 27 and the first gate pad 37 and auxiliary pad 56 of the first transistor device 25 remains uncovered by the third lead 23. The second transistor device 26 has a lateral extent which is smaller than the lateral extent of the first transistor device 25 such that the first gate pad 37 and auxiliary pad or pad 56 of the first transistor device 25 remains uncovered by the second transistor device 26. The second lead 22 has a lateral extent which is smaller than the lateral extent of the second transistor device 26 so that the second gate pad 40 and auxiliary pads 56 arranged on the second surface 32 of the transistor device 26 remains exposed from the second lead 22. The leads 18, 22, 23 extends to side face of the semiconductor package 10 which forms the lower surface 11 so that the side faces of the leads 18, 22, 23, which form the outer contact pads 12, 13, 14 are located in the lower surface 11 of the semiconductor package. 10.. In some embodiments, in addition to the lower side faces which provide the outer contact pads of the package 10, one or more of the further side faces of the leads 18, 22, 23 may be exposed from the mold compound 16, for example in the top surface 17 as shown in figure 1H.

The plurality of control leads 15 may be formed of the same material as the leads 18, 22, 23, for example a metal or alloy, for example copper. The control leads may be formed by metallic blocks for example. The control leads 15 and the first lead may be formed by structuring a metallic plate or sheet to form the plurality of leads 15 and the first lead 18 from that plate or sheet.

The first gate pad 37 and the second gate pad 40 may be electrically connected to the control chip 27 by a one or more additional connectors, such as bond wires. The control chip 27 is also connected to at least one of the control pads 15 by one or more additional connectors, such as a bond wire.

Figure 1G illustrates a perspective top view of a semiconductor package 10' according to another embodiment. In this embodiment, the third lead 18 includes at least one recess 42 in one or both of the inner surfaces 30, 33 of the third lead 23. The recess 42 is sized and shaped to receive one of the devices, for example the first transistor device 25 or the second transistor device 26.

In the top perspective view of figure 1G, a recess 42 can be seen which is formed in the second inner surface 33 in which the second semiconductor device 26 is mounted. In particular, the first power pad 38 on the first surface, which forms the source pad of the second transistor device 26 is arranged on the base of the recess 42. This embodiment may be useful for decreasing the width of the package and allowing the contact pads 12, 13, 14 provided by the lower surfaces of the first, second and third leads 18, 22, 23, respectively, to be arranged closer together. In other embodiments, the first lead 18 and the second lead 22 may also include a recess in which the first transistor device 25 and second transistor device 26, respectively, are arranged.

Figure 1H illustrates a perspective view of a semiconductor package 10", in which the first, second and third leads 18, 22, 23 each extend from the lower surface 11 to the opposing top surface 17 of the semiconductor package 10" and each have a side face 12, 13, 14' which is exposed from the mold compound 16 in the top surface 17. These upper side faces form a second low voltage pad 12', a second high voltage pad 13' and a second output pad 14'. This arrangement may also assist with increasing cooling.

Additionally, a capacitor 43, for example a boot capacitor, can be mounted on these upper side faces. In Figure 1H, a bootstrap capacitor 43 is shown which Is mounted on and electrically connected to the second output pad 14' and the high voltage pad 13'. This arrangement is useful, as the capacitor can be added to the package without occupying space on the board 1000 and thus saves space on the board 1000.

For fabricating the semiconductor packages 10, 10', 10" the first and second transistor devices 25, 26 and control chip 27 can be attached to the leads by standard soft soldering processes, for example a solder reflow process.

The arrangement of the semiconductor packages 10, 10', 10" has a low resistance between the first and second transistor devices 25, 26 of the half bridge as both transistor devices 25, 26 are mounted on opposing sides of the third lead 23. Furthermore, the control contact pads 15 located in the lower surface 11 are also visible from the side 19 of the package 10, 10', 10" which enables easier alignment at the user end.

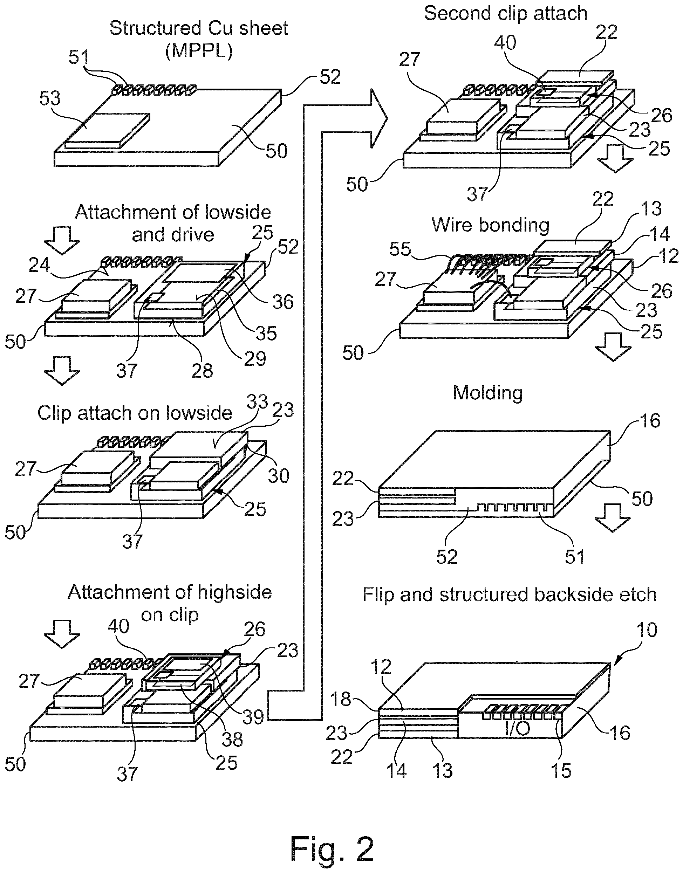

Figure 2 illustrates a method for fabricating a semiconductor package. The method may be used to fabricate the semiconductor package 10 according to one of the embodiments illustrated with reference to figure 1 and will be described with reference to this package. The method is illustrated for a single semiconductor package 10. However, typically, a plurality of semiconductor packages is manufactured at the same time in the form of a panel having a plurality of component positions, each component position providing a package. The panel is then singulated, for example diced with a mechanical saw or with a laser, to separate the individual packages from the panel.

A structured sheet 50 is provided which is formed of metal, for example copper, that is to provide the first lead 18 with its low voltage contact pad 12 and the control contact pads 15 of the package 10. The sheet 50 includes a plurality of protrusions 51 at an edge of the sheet which are to form individual leads, each providing a control contact pad 15. The protrusions 51 have a horizontal surface which protrudes from the inner surface 24 of the sheet 50 and has a vertical side face formed by the side face 52 of the sheet which will form not only the control contact pads 15, but also the lower surface of the first lead 18 and the low-voltage contact pad 12. In some embodiments, the inner surface 24 of the sheet 50 also includes a raised pedestal 53 onto which the control chip 27 is to be mounted. The pedestal 53 may have a height such that the upper surface of the control chip 27 is positioned in a plane suitable for providing wire bonds to the first and second transistor devices 25, 26 which are arranged in the stack as well as to the protrusions 51 which are to form the lead providing the output control pads 15.

The control chip 27 is mounted on the pedestal 53, for example, using a solder connection. The source pad 35 on the first major surface 28 of the first transistor device 25 is attached to the inner surface 24 of the sheet at a position laterally adjacent the control chip 27 and laterally adjacent the protrusions 51. The drain pad 36 and first gate pad 37 on the second major surface 29 face upwards and away from the metallic sheet 50. The source pad is, therefore, electrically connected to the metallic sheet 50. The first gate pad 37 is arranged in a corner of the second major surface 29 and arranged such that it is laterally adjacent the control device 27 in order to better facilitate wire bonding of the first gate pad 37 to the control device 27.

The first major surface 30 of the third lead 23 is then applied to the second surface 29 of the first transistor 25 and is mounted on and electrically connected to the drain pad 37. The third lead 23 has an L-shape with a cutout and the first gate pad 37 is arranged in the cutout such that it is remains exposed from, and uncovered by, the third lead 23. If the third lead 23 is provided as an individual lead rather than as part of a panel, it is sized and shaped such that it has a side face which is substantially parallel with the lower side face 52 of the metallic sheet 50 which is to form the low voltage contact pad 12.

The second transistor device 26 is then mounted on the upwardly facing second inner surface 33 of the third lead 23 such that the source pad 38 on the first surface 31 is electrically connected to the third lead 23 and such that the drain pad 39 and the second gate pad 40 face upwardly. The gate pad 40 is arranged in a corner of the second surface 32 and arranged such that it is laterally adjacent the control chip 27 to better facilitate wire bonding. The area of the first and second major surfaces 31, 32 of the second transistor device 26 smaller than the lateral size of the first transistor device 25 so that the first gate pad 37 as well as a portion of the third lead 23 remain uncovered by the second transistor device 26. The second lead 22 is then mounted on the second transistor device 26 and is electrically connected to the drain pad 39 and leaves the second gate pad 40 and also the first gate pad 37 of the first transistor devices and any auxiliary pads 56 uncovered. The second lead 22 has a lateral extent that is smaller than the third lead 23. In embodiments, in which the second lead 22 is provided as an individual lead, rather in as a component position of a panel, it has a side face which is substantially coplanar with the side face of the third lead 23 and side face 52 of the metallic sheet 50 which are to form the pads of the final semiconductor package 10.

A wire bonding process is then carried out to electrically connect the control chip 27 to the first gate pad 37, the second gate pad 40 and the protrusions 51. In other embodiments, the wire bonds 55 may be replaced by conductive ribbons or contact clips. In some embodiments, the second major surface of one or both of the transistor devices 25, 26 further includes one or more auxiliary pads, such as a source sense pad, which may remain uncovered by the third lead 23 and second lead 22, respectively, and which can be electrically connected to the control chip 27 by further wire bonds.

A molding process is carried out which covers the first and second transistor devices 26, 27, the control chip 27, the bond wires 55, the inner surface 24 of the metallic sheet 50, the inner surface 34 of the second lead 22 and the first and second inner surfaces 30, 33 of the third lead 23. In some embodiments, the outer surface of the second lead 22 is covered by the mold compound 16 as is illustrated in figure 2. In some embodiments, the outer surface of the second lead 22 is at least partially exposed from the mold compound 16. The outer surface 19 of the metallic sheet 50 remains uncovered by the mold compound 16. The metallic sheet 50 is then structured so as to separate the protrusions 51 from the sheet 50 and form a plurality of separate leads each having a side face that provides a control pad 15. The control pads 15 are arranged in a row with the low-voltage contact pad 12, since both are formed from the side face 52 of the sheet 50. After structuring of the metallic sheet 50 to form the first lead 18 and control leads 15, the first lead 18 may have an L-shape with the plurality of control contact pads 15 arranged in the cutout of the first lead 18 and spaced apart from the first lead 18 at the first package side face by intervening regions of the mold compound 16.

The metallic sheet 50 can be fabricated from a planar sheet by etching (for example by a half etch process) to form the protrusions 51 for the leads providing the control contact pads 15 and pedestal 53. The control device 27 and the source pad 35 of the first transistor device 25 forming the low side switch may be mounted onto the first lead 18 by soldering, gluing or other, similar die/clip-attach methods. Afterwards, a first lead attach process is carried out to attach the third lead 23 directly on the drain pad 36 of the first transistor device 25, the second transistor device 26 forming the high side switch can be mounted with its source pad 38 on the third lead 23 or in a cavity or recess or indentation 42 formed in the surface of the third lead 23 depending on its dimensions. The second lead 22 is attached by soldering, gluing or other die/clip-attach methods on the drain pad 39 of the second transistor device 26 before the reflow of the whole stack is performed. Now the wire bonding between the gate pads 37, 40 and sense pads 56 etc, if present, of the first and second transistor devices 25, 26 and the control chip 27, as well as the connections between the control chip 27 and the protrusions 51 is performed, before the package is molded. In the next step, a second structured half etch process is carried out on the backside of the metallic sheet 50 to separate the pre-etched control leads 11 and the first lead 18 from the sheet. The rest of the surface, which will be the ground potential, remains untouched in order to generate a cooling surface for the package.

In a later process for embodiments in which a stacks are built up in each of a plurality of component positions of a panel, singulation is performed, e.g. by mechanical dicing through the mold compound 16 and the metal leads 18, 22, 23. This process has an additional purpose to not only separate the packages from the panel but also uncover the control contact pads 15, the low voltage pad 12, the high voltage pad 13 and the output pad 14 formed by the side faces of the leads 18, 22, 23. Afterwards a noble/ wettable pad finish of the single devices may be applied by electro-less plating, electroplating or similar approaches in a drum concept.

Optionally the singulation can be performed in two stages with one dicing channel at first, which leads to singulated strips, still connected by an outer frame. In this embodiment, the noble/ wettable pad finish may be applied, for example with a dipapproach, before a second channel is diced to complete singulation and separate the packages.

The resulting vertical power package can now be rotated, placed vertically and connected by way of the side face 11 including the contact pads 12, 13, 14, 15 to the PCB. The board connection is achieved through the accessible pads (labelled GND, Switch, Vin, I/O in the drawings) at the package lower surface 11 of the package10. 10'.

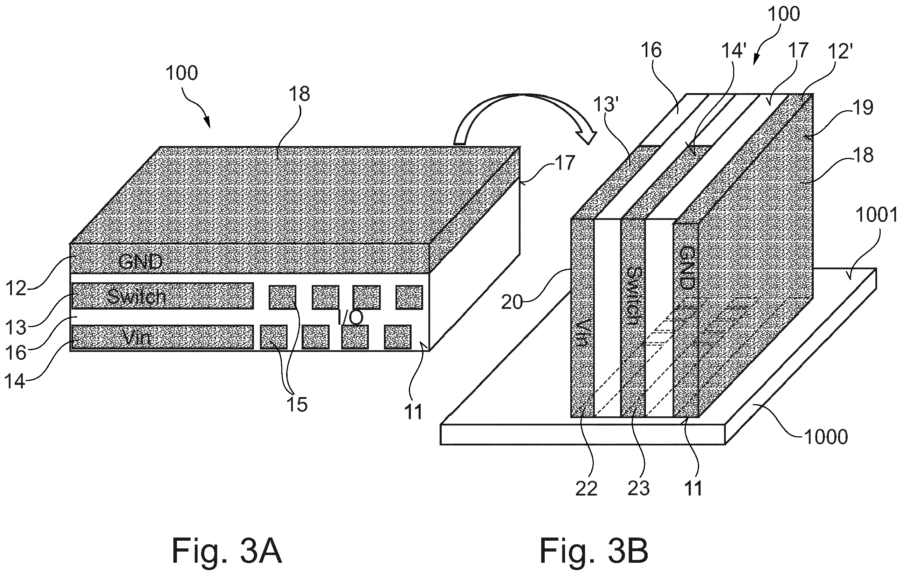

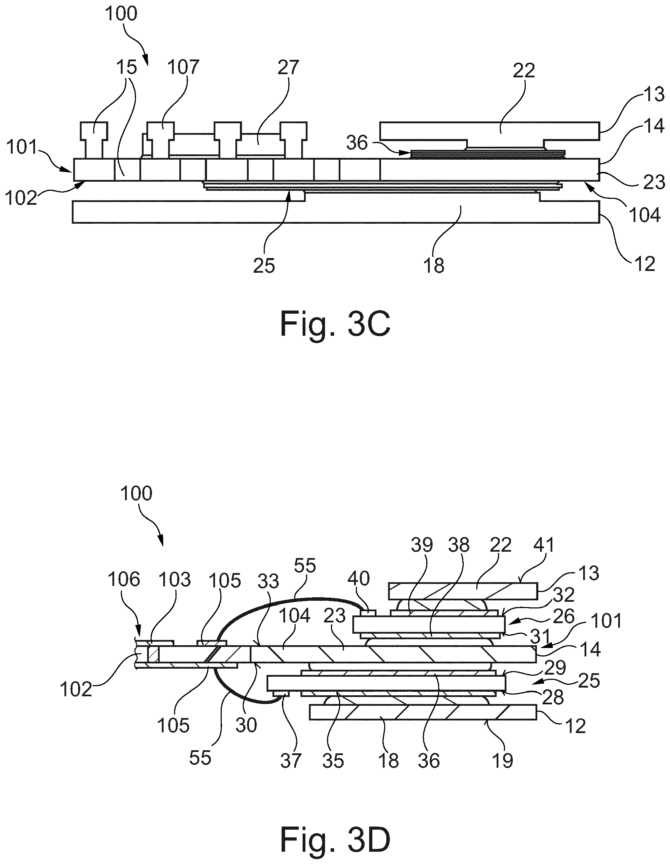

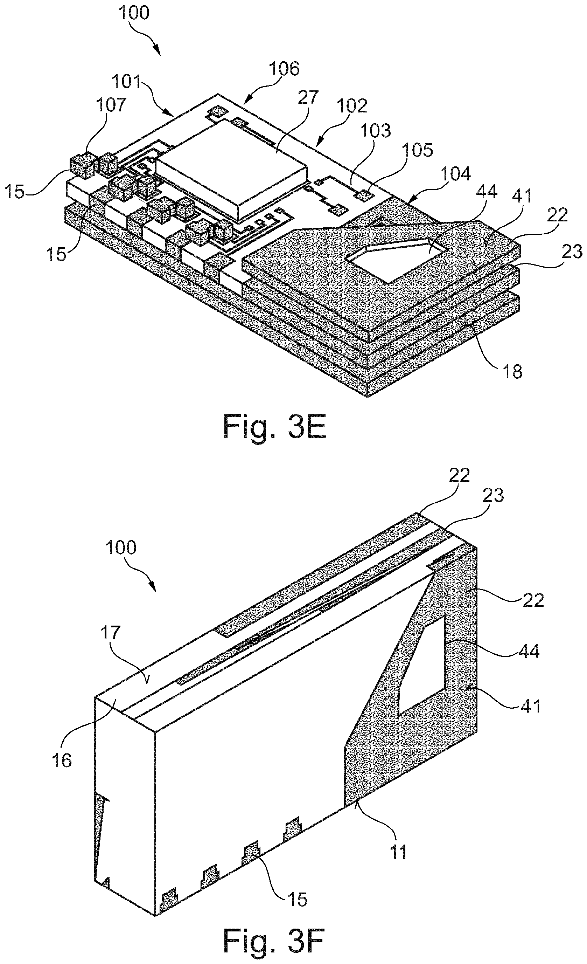

Figure 3, which includes figures 3A to 3F illustrates various views of a semiconductor package 100 according to an embodiment. Figure 3A illustrates a perspective view of the lower surface 11 of the semiconductor package 100, figure 3B illustrates the semiconductor package 100 mounted on a circuit board 31 in a vertical orientation, figure 3C illustrates a side view of the semiconductor package in which the mold compound is not shown, figure 3D illustrates an enlarged cross-sectional view, figure 3E illustrates a perspective view of the semiconductor package in which the mold compound is not shown and figure 3F illustrates a perspective view of the package including the mold material.

As can be seen in figure 3C and similar to the semiconductor package 10 described with reference to figures 1 and 2, the semiconductor package 100 comprises a lower surface 11 comprising a low-voltage contact pad 12, a high-voltage contact pad 13, an output or switch contact pad 14 and a plurality of control contact pads 15. The semiconductor package 100 is mounted vertically, i.e. perpendicularly to the first major surface 1001 of the circuit board 1000 by way of the lower surface 11.

Referring to figures 3C and 3E, the semiconductor package 100 also comprises a half bridge circuit including a first transistor device 25 and a second transistor device 26 which are electrically coupled in series at an output node and a control chip 27 that is electrically coupled to the first transistor device 25 and the second transistor device 26.

Referring to figures 3A and 3B, similar to the embodiment illustrated in figure 1, the low-voltage contact pad 12, the high-voltage contact pad 13 and the upper contact pad 14 each have an elongate stripe-like shape and are arranged substantially parallel to one another in the lower surface 11 of the package 100. The output contact pad 14 is arranged laterally between the low-voltage output pad 12 and the high-voltage output pad 13 in the lower surface 11 of the package 100. In this embodiment, the control contact pads 15 are arranged in two rows, the first row has a length that is aligned with the longest dimension of the high-voltage output pad 13 to form a row and the second row has a length that is aligned with the longest dimension of the output contact pad 14. The low-voltage contact pad 12 extends over the entire length of the lower surface 11 whereas the high-voltage contact pad 13 and the output contact pad 14 extend over only a portion of the so as to leave space for the two rows of control contact pad 15.

Similar to the package 10 illustrated in figure 1, the low-voltage contact pad 12 is formed by the lower side face of a first lead 18 which has an inner surface 24 which extends substantially perpendicularly to the lower surface 11 of the package 100. Similarly, the high-voltage lead high-voltage pad 13 is formed by the lower surface of a second lead 22 which has an inner surface 34 which extends substantially perpendicularly to the lower surface 11 of the semiconductor package 10. The output contact pad 14 is provided by the lower side face of third lead 23 which has a first inner surface 30 and a second inner surface 31 opposing the first surface 30. The third lead 33 is arranged between the first lead 18 the second lead 22 and the leads 18, 22, 23 can be considered to be arranged in a stack which has a stacking direction that is substantially parallel to the lower surface 11 of the package 100.

The first, second and third leads 18, 22, 23 also extend to the top surface 17 of the semiconductor package 100 and provide a further low voltage contact pad 12', high voltage contact pad 13' and output contact pad 14' at the top surface 17. A capacitor can be mounted on the top surface and electrically connected to one or more of these contacts, for example between the high voltage contact pad 13' and output pad 14' in the case of a bootstrap capacitor.

Referring to the enlarged cross-sectional view of figure 3D, the first transistor device 25 has a first major surface 28 including a first power contact pad, which in this embodiment is a source pad 35 and a second major surface 29 having a second power contact pad 36, which is a drain pad. The transistor device 25 differs from that described with reference to figures 1 and 2 in that the first gate pad 37 is arranged on the first major surface 28 of the transistor device 25 and laterally adjacent to the source pad 35. The second transistor device 26 has the same arrangement as that illustrated in figure 1 and includes a source pad 38 on its first major surface 31 and a drain pad 39 and second gate pad 40 on its second major surface 31.

As can be seen in the perspective view of figure 3E, the third lead 23 is formed by a portion of a routed leadframe101 which includes a first portion comprising an electrically insulating material 102 as a matrix and a second conductive portion 104 which is arranged laterally adjacent and is having joined to the first electrically insulating portion 102. The electrically insulating portion 102 includes a conductive redistribution structure 106 which comprises a plurality of conductive traces 103 and bond pads 105 formed on the opposing major surfaces which form the first and second inner surfaces 31, 33 of the third lead in the final package 100. The conductive traces 103 on the two opposing surfaces 31, 33 of the routable leadframe101 are electrically connected by conductive vias of the conductive redistribution structure 106 which extend through the thickness of the insulating material 102 between the opposing major surfaces.

The electrically conductive portion 104 is formed of metallic material, such as copper, copper alloy or similar and which has a thickness corresponding to the thickness of the insulating material 102 of the routed lead frame 101. Therefore, this conductive portion 104 of the lead frame 101 is integral and attached to the insulation material 102 and has a lower side face which forms the output contact pad 14.

Referring to figures 3DC and 3E, the control device 27 and the second transistor device 26 are mounted on the second surface 33 of the lead frame 101. The control device 27 is mounted on the electrically insulating matrix 102. The control device may be mounted on a die pad provided by one of the traces 103 on the second surface 33. The second transistor device 26 is mounted on the electrically conductive portion 104 laterally adjacent to the control device and on the same side of the third lead 23 as the control device 27.

The first power pad 28 of the second transistor device 26, which provides the source pad, is mounted on the second inner surface 33 of the third lead 23. The control device 27 is, therefore, arranged within the package 100 laterally adjacent to the second transistor device 26 which provides the high side switch of the half bridge circuit. This is in contrast to the semiconductor package 10 described with reference to figures 1 and 2, in which the control device 27 is arranged laterally adjacent the first transistor device 25 which provides the low side switch of the circuit and on the opposing inner surface of the third lead 23 from the second transistor device 26 which provides the high side switch of the half bridge circuit.

The second lead 22 is mounted on the second surface 32 of the second transistor device 26 and on the second power pad 39 which provides the drain pad. The second lead 22 has a shape such that the gate pad 40, which is arranged on the second side 32 of the second transistor device 26 remains uncovered by the second lead 22. For example, the second lead 22 may have a substantially rectangular form with one corner removed to form a polygon and the second gate pad 40 is arranged in the cutout.

The control contact pads 15 are provided by the lower surface of individual leads 107 which are mounted on the second surface 33 of the leadframe 101 on the electrically insulating portion 102 and, in particular, on conductive traces 103 of the routable lead frame 101. The lower side face of the leads 107 may be substantially coplanar with the lower side face of the second lead 22 which forms the high-voltage contact pad 13 of the package 100. The second row of control contact pads 15 may be formed by conductive regions 106 formed on the side face of the leadframe 101 which are embedded within the electrically insulating matrix 102 of the leadframe 101 and which are electrically connected to the conductive traces 103. The first transistor device 25 is mounted on the opposing first inner surface 31 of the leadframe 101 and on the electrically conductive portion 104 which provides the third lead 23.

The first transistor device 25 is mounted on the first inner surface 30 of the conductive portion 104 of the leadframe 101 that provides the third lead 23 such that the second power pad 36, which provides the drain pad, on the second surface 29 is mounted on the third lead 23. The first power pad 35, which provides the source pad, is arranged on the opposing first surface 28 of the first transistor device 25 is mounted on the inner surface of the first lead 18. In this embodiment, the first gate pad 37 is arranged on the first major surface 28 of the first transistor device 25 laterally adjacent to the source pad 35. The first lead 18 has an L-shape and is arranged so that the first gate pad 37 remains uncovered by the first lead 18. The first gate pad 37 is electrically connected to conductive traces 103 and/or bond pads arranged on the first side 31 of the electrically insulating matrix 102 of the lead frame 101. These conductive traces 103 and bond pads 105 are electrically connected to the control device 27 which is arranged on the opposing second inner surface 33 of the leadframe 101 by means of the conductive redistribution structure including the conductive vias extending through the thickness of the insulating matrix 102 and the conductive traces 103 arranged on the opposing second surface 33 of lead frame 101.

In some embodiments, the second lead 22 may include a recess 44 in its outermost surface 41 which is filled by the mold material 16 in the molded semiconductor package as can be seen in the perspective view of figure 3F. The remainder of the outer surface 41 is exposed from the mold compound 16.

The routable leadframe 101 includes large area metallic, e.g. copper, contact surfaces for the first and second transistor devices 25, 26 on front and backside of the original Cu sheet. The rest of the leadframe 101 is filled by electrically insulating material, such as a mold compound, with individual through-hole platings which are necessary for the gate and auxiliary connections between first transistor device 25 and the control device 27. The conductive traces 103 and bond pads 105 may be formed by applying a metallic foil to the opposing major surfaces or deposition of a metallic layer on the opposing major surfaces, e. g. by sputtering and electroplating or by electroless plating. If applied in such a way, the closed metallic layer is then patterned.

In another embodiment, the routable leadframe is replaced by a redistribution board formed of reinforced board, for example a fibre-reinforced epoxy board that includes a metallic block extending between the opposing surfaces to provide the conductive portion 102 and the third lead 23. The redistribution board provides the electrically insulating portion 102 and includes a conductive redistribution structure including conductive traces, bond pads and conductive vias in the board that electrically connect the traces and bond pads on the two opposing sides with one another.

In another embodiment, the routable leadframe is replaced by a molded interconnect substrate (MIS). In this case, the isolating material of the substrate is mold compound having a planar shape which forms the matrix and metal blocks are included in the electrically insulating matrix, similar to the routable leadframe. The molded interconnect substrate further comprises a conductive redistribution structure which is applied to both sides of the mold compound. The conductive redistribution structure may be applied by sputtering and electroplating or electroless plating without sputtering.

The two rows of control pads 15 may be arranged in a square grid array of rows and columns or in offset rows in a checkboard arrangement. The arrangement of the control pads 15 in two rows in the lower surface 11 of the semiconductor package 100 and aligned in checkerboard arrangement enable improved connectivity for customer on board and easy pitch realization. There is space on the top surface 17 of the package 100 for additional capacitors. The Vin as well as Gnd potential pads, providing by the side faces of the second and first leads 22, 18, respectively, with large metallic flanks on both sides 19, 20 of the package 100 and can be used for a good thermal management similar to double side cooling technology.

The Vertical Power Package according to any one of the embodiments described herein improves design flexibility on the user's board. With the described vertical packages, it is possible for the user to place more power converters even closer to the CPU/GPU compared to conventional horizontal devices. This also assists in reducing parasitic power losses for the whole system.

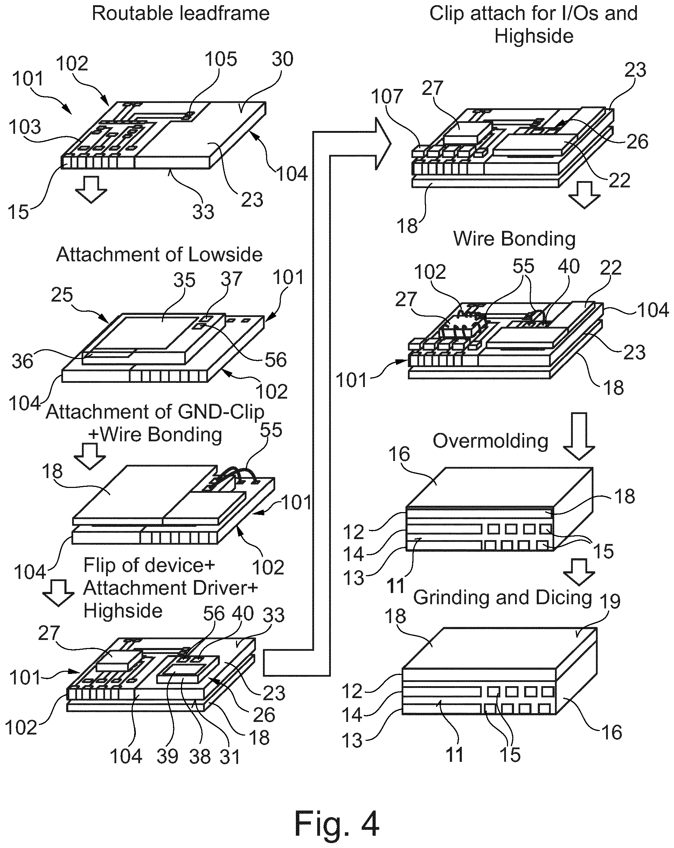

Figure 4 illustrates a method for fabricating the semiconductor package 100. The method is illustrated for a single semiconductor package. However, a plurality of semiconductor packages is may be formed at the same time in the form of a panel having a plurality of component positions, each component position providing a package. The panel is then singulated to provide the individual packages.

A lead frame 101 is provided which includes a portion 102having an electrically insulative matrix and a conductive portion 104 that are laterally adjacent one another. The electrically insulating portion 102 has a conductive redistribution structure 106 which includes a plurality of conductive traces 103 extending into bond pads 105 on each of the two opposing surfaces 31, 33. The redistribution structure 106 also includes conductive vias 108 which extend through the thickness of the electrically insulating matrix 102 to electrically connect the conductive traces 103 and bond pads 105 on the two opposing sides 31, 33 to one another. The lead frame 101 also includes a plurality of conductive areas arranged in a row at the side face which is to be positioned in the lower surface 31 of the package. These conductive areas provide a row of control contact pads 15. The conductive area may be formed by the side face of a conductive metallic lead. The conductive portion 104 of the routable lead frame 101 is formed of metallic material, e.g. copper, and extends from the first and the side 31 to the opposing second inner side 33 and which is used as the conductive node of the half bridge circuit.

The first transistor device 25 is attached to the first inner surface 31 so that the second power pad 36 on the second surface 29, which provides the drain pad, is mounted on the conductive portion 104 and on the first inner surface 31. The first power pad 35, which provides the source pad, and the first gate pad 37, which are arranged on the first major surface 28 of the first transistor device 25, face upwardly. The first lead 18 which is to provide the low-voltage contact pad has an L-shape and is mounted on, and electrically connected to, the source pad 35. The cutout of the first lead 18 which provides the L-shape is arranged such that the first gate pad 37 is arranged in the cutout and is uncovered by the first lead 18. The gate pad 37 may be arranged above the electrically insulating matrix 102 and is electrically connected by bond wires 55 to bond pads 105 arranged on the first inner surface 31 of the leadframe 101.

The leadframe 101 is then inverted and the control device 27 is then mounted onto the opposing second inner surface 33 of the lead frame 101 such that it is mounted on the electrically insulative portion 102. The second transistor device 26 is mounted on the electrically conductive portion 104 of the second surface 33 such that the first power pad 38 arranged on its first side 31, which provides the source pad, is mounted on and electrically connected to the conductive portion 104 of the leadframe 101 that provides the third lead 23. The second power pad 39 which provides the drain pad, and the second gate pad 40 which are arranged on the second major surface 32 face upwardly. The second transistor device 26 may be arranged above the first transistor device 25 in a stacked arrangement. The second lead 22 is arranged on the drain pad 39 such that the second gate pad 40 remains uncovered by the second lead 22.

A plurality of leads 107 are also arranged on conductive traces 103 or bond pads 105 on the second surface 33 of the electrically insulating matrix 102. The plurality of leads 107 are arranged laterally adjacent the control device 27 such that they are substantially coplanar with the second lead 22 and such that they have a side face which extends substantially perpendicularly to the second major surface 32 of the second transistor device 26 and substantially perpendicular to the second inner surface 33 of the leadframe 101. The second gate pad 40 of the second transistor device and the leads 107 are then electrically connected to the control device 27, for example by bond wires 55. The control device 27 is also electrically connected to some of the conductive traces 103 by for example bond wires 55. At least one of the conductive traces 103 is electrically connected to the first gate pad 37 of the first transistor device 25 which is arranged on the opposing first and the surface 31 of the lead frame 101 by means of the conductive redistribution structure 106 and conductive vias 108 arranged within the electrically insulating matrix 102.

The arrangement is then molded. If a panel is formed including a plurality of component positions, each having been processed as described above, the individual packages 100 are singulated or diced from the panel. A grinding process may be carried out to for example to remove the mold compound 16 from the outer surface of the first lead 22 and/or to smooth the contact pads 12, 13, 14, 15 in the lower surface 11 of the semiconductor package 100 if these are formed by dicing.

The drain pad 36 of the first transistor device 25 forming the low side switch is attached to the metallic portion 104 of the routable leadframe substrate 101, with a glue attach, sintering or similar process, followed by attaching the first lead 18 to the source pad 35 of the first transistor device 25. After this first stack has been cured, the wire bonding between the bond pads 105 and the first gate pad 37 and any auxiliary pad(s) 56 of the first transistor device 25 can be performed. Optionally, the bond wires 55 can be protected by a small globe top or similar coverage material. The arrangement is then inverted or flipped. The first lead 18, which can also be referred to as a GND-Clip, covers a large area of the device backside, reaching to all sidewalls of the device and can therefore be used as a carrier after the arrangement has been flipped. The second transistor device 26 providing the high side switch and the control device 27 are then mounted on the opposing side 33 of the MIS/ routable leadframe 101. Moreover, the first lead 18 can later be connected from all sidewalls of the package. The mounting of the second transistor device 26 and control device 27 may be carried out by glue attach or sintering process. Afterwards the second lead 22 is attached onto drain pad 39 of the second transistor device 26, and cured. Like the first lead 18, the second lead 22 or Vin-clip also reaches to the outer edges of the MIS/ routable leadframe 101, which allows the accessibility for further devices, cooling functions or customer board, after the package is completed.

Now, the wire bonding has to be performed on the top side of the MIS/ routable leadframe 101, to connect the gate pad 40 and any auxiliary pad 56 of the second transistor device 26 to the control device 27 and the control device 27 to the control leads 107. Then the whole package is molded. Like in the previous method, the package is now partially or fully singulated, e.g. by mechanical dicing from the panel with the additional purpose to not only separate the devices but also uncover the connection pads, formed by the side faces of the clips and substrate providing the leads 18, 22, 23. Depending on this, the noble/ wettable pad finish is applied either as drum or dip process (electro-less plating, electroplating or similar approach). The resulting vertical power package can now be rotated, placed vertically with respect to the major surface of a PCB and connected along one side to the PCB. The board connection is achieved through the accessible layers provided by the contact pads denoted GND, Switch, Vin, I/O in the drawings, at the package sidewall which now forms the lower surface 11 of the package 100.

The first lead 18 connected to the source pad 35 of the low side transistor 25 is used as GND potential and provides the low voltage pad, while the routable leadframe 101 itself is at the switch potential and the output pad 14. The smaller third lead 23 on the drain pad 39 of the second transistor device is at Vin potential and provides the high voltage contact pad 13 of the semiconductor package 100. Some of the control pads 15 are implemented in the edge of the routable leadframe 101, while the other control pads 15 and third lead 18 are realized by leads 107 formed by structuring the sheet, for example by etching. The leads 107 may be separated from the portion of the third lead 23 which is at Vin potential in the final package 100 during singulation.

Semiconductor packages with a vertical arrangement of power chips 25, 26 and the control device 27 with respect to the lower package surface 11 in which the outer contact pads are arranged, also with respect to the surface 1001 of the circuit board 1000 on which the package 100 is mounted are provided by using well known horizontal process technologies. All of the leads, whether provided by a clip or a substrate in the form of a leadframe or MIS / routable leadframe, are accessible at one or more package edges. The side faces of clips and substrates are exposed from the mold compound and are directly used for board level assembly, application of passives (e.g. conductors, inductors or capacitors), or additional cooling features.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor package (10, 10', 10", 1000), comprising:
a lower surface (11) comprising:
a low voltage contact pad (12);
a high voltage contact pad (13);
an output contact pad (14), and
at least one control contact pad (15);
at least one half-bridge circuit comprising a first transistor device (25) having a first major surface (28) and a second transistor device (26) having a first major surface (31), the first and second transistor devices (25, 25) being electrically coupled in series at an output node,
at least one control device (27) that is electrically coupled to the first transistor device (25) and the second transistor device (26),
wherein the first major surface (28) of the first transistor device (25) and the first major surface (31) of the second transistor device (26) are arranged substantially perpendicularly to the lower surface (11) of the semiconductor package (10, 10', 10", 1000).

2. A semiconductor package (10, 10', 10", 1000) according to claim 1, further comprising:
a first lead (18) that has an inner surface (24) that extends substantially perpendicularly to the lower surface (11) and a lower side face that forms the low voltage contact pad (12),
a second lead (22) that has an inner surface (34) extends substantially perpendicularly to the lower surface (11) and a lower side face that provides the high voltage contact pad (13), and
a third lead (23) having a first inner surface (30) and a second inner surface (33) opposing the first inner surface (30), wherein the first transistor device (25) is mounted on the first inner surface (30) and the second transistor device (23) is mounted on the second inner surface (33) and the third lead (23) provides the output node,
wherein the first lead (18) is arranged at a first package side face (19), the second lead (22) is arranged at a second package side face (20) that opposes the first package side face (19) and the third lead (23) has a lower side face that is arranged in the lower surface (11) between the low voltage contact pad (12) and the high voltage contact pad (13).

3. A semiconductor package (10, 10', 10", 1000) according to claim 1 or claim 2, wherein the at least one control contact pad (15) is arranged in a common plane with the low voltage contact pad (12) or wherein the at least one control contact pad (15) is arranged in a common plane with the high voltage contact pad (13) and/or with the output contact pad (14).

4. A semiconductor package (10, 10', 10", 1000) according to any one of claims 1 to 3, wherein the low voltage contact pad (12), the high voltage contact pad (13) and the output contact pad (14) each have a width that is less than or equal to a thickness of the first lead (18), the second lead (22) and the third lead (23), respectively and a length that is less than the length of the lower surface (11) of the package (10, 10', 10", 1000).

5. A semiconductor package (10, 10', 10", 1000) according to any one of claims 1 to 4, wherein
the first transistor device (25) comprises a first power pad (35) on the first major surface (28) and a second power pad (36) on a second major surface (29) opposing the first major surface (28) and
the second transistor device (26) comprises a first power pad (38) on the first major surface (31) and a second power pad (39) on a second major surface (32) opposing the first major surface (31),
wherein the second power pad (36) of the first transistor device (25) is mounted on the first inner surface (30) of the third lead (23) and the first power pad (38) of the second transistor device (26) is arranged on the second inner surface (33) of the third lead (23),
wherein the first lead (18) comprises an inner surface (24) attached to the first power pad (35) of the first transistor device (25) and the second lead (22) comprises an inner surface (34) attached to the second power pad (39) of the second transistor device (26).

6. A semiconductor package (10, 10', 10", 1000) according to any one of claims 1 to 5, wherein the third lead (23) comprises a recess (42) in which the second transistor device (26) is arranged.

7. A semiconductor package (10, 10', 10") according to claim 5 or claim 6, wherein the first transistor device (25) further comprises a first gate pad (37) on the second major surface (29) and the second transistor device (26) further comprises a second gate pad (40) on the second major surface (32).

8. A semiconductor package (10, 10', 10") according to claim 7, wherein the control device (27) is mounted on the first lead (18).

9. A semiconductor package (10, 10', 10") according to claim 7 or claim 8, wherein the control device (27) is electrically connected to the first gate pad (37), the second gate pad (40) and the control pads by bond wires (55).

10. A semiconductor package (100) according to claim 5 or claim 6, wherein the first transistor device (25) further comprises a first gate pad (37) on the first major surface (28) and the second transistor device (26) further comprises a second gate pad (40) on the second major surface (32).

11. A semiconductor package (100) according to claim 10, wherein the third lead (23) is provided by a leadframe (101) comprising electrically insulating material (102) on which conductive traces (103) and the control pads (15) are formed and the control device (27) is mounted on the leadframe (101).

12. A semiconductor package (100) according to claim 10 or clam 111, wherein the first gate pad (37) and the second gate pad (40) are connected to the conductive traces (103) of the leadframe (101) by a bond wire (55) and the control device (27) is connected to the control pads (15) and/or conductive traces (103) by a bond wire (55).

13. A semiconductor package (10, 10', 10", 1000) according to any one of claims 1 to 12, comprising a first half bridge circuit and a second half bridge circuit that are electrically coupled to form a full bridge circuit.

14. A method of fabricating a semiconductor package (10, 10', 10"), the method comprising:
providing a first transistor device (25) comprising a first power pad (35) on a first major surface (28) and a second power pad (36) and a first gate pad (37) on a second major surface (29) that opposes the first major surface (28);
providing a second transistor device (26) comprising a first power pad (38) on a first major surface (31) and a second power pad (39) and a second gate pad (40) on a second major surface (32) that opposes the first major surface (31);
attaching at least one control device (27) and the first power pad (35) of the first transistor device (25) to an inner surface (24) of a first lead (18);
attaching a first inner surface (30) of a third lead (23) to the second power pad (36) of the first transistor device (25);
attaching the first power pad (38) of the second transistor device (26) to a second inner surface (33) of the third lead (23), the second inner surface (33) opposing the first inner surface (31);
attaching a second lead (22) to the second power pad (39) of the second transistor device (26),
electrically connecting the first gate pad (37) and the second gate pad (40) to the control device (27) ;
electrically connecting the control device (27) to at least one control contact pad (15) that is integrally formed in the first lead (18),
applying a mold compound (16) that covers the inner surfaces of the first, second and third leads (18, 22, 23), the first and transistor devices (25, 26);
patterning the first lead (18) to separate the control contact pads (15);
wherein the at least one control contact pad (15), and side faces (12, 13, 14) of the first, second and third leads (18, 22, 23) that are arranged substantially perpendicularly to the respective inner surface are arranged in a common plane (11) that is substantially perpendicular to the first major surface (28) of the first transistor device (25).

15. A method of fabricating a semiconductor package (100), the method comprising:
providing a first transistor device (25) comprising a first power pad (35) and a first gate pad (37) on a first major surface (28) and a second power pad (36) on a second major surface (29) that opposes the first major surface (28);
providing a second transistor device (26) comprising a first power pad (38) on a first major surface (31) and a second power pad (39) and a second gate pad (40) on a second major surface (32) that opposes the first major surface (31);
attaching the second power pad (36) of the first transistor device (25) to a first inner surface (30) of an electrically conductive portion (104) of a leadframe (101), the electrically conductive portion providing a third lead (23), wherein the leadframe (101) further comprises an electrically insulating portion (102) on which conductive traces (103) and at least one control pad (15) are formed;
attaching an inner surface (24) of a first lead (18) to the first power pad (35) of the first transistor device (25);
electrically connecting the first gate pad (37) to a first conductive trace (103) on the first inner surface (30) of the leadframe (101) ;
attaching the first power pad (38) of the second transistor device (26) to a second inner surface (33) of the conductive portion (104) of the leadframe (101) providing the third lead(23) , the second inner surface (33) opposing the first inner surface (31);
mounting a control device (27) on the second inner surface (33) of the electrically insulating portion (102) of the leadframe (101);
attaching a second lead (22) to the second power pad (39) of the second transistor device (26);
electrically connecting the second gate pad (40) to a second conductive trace (103) on the second inner surface (33) of the electrically insulating portion (102) of the leadframe (101) ;electrically connecting the control device (27) to at least one third conductive trace (103) , the at least one third conductive trace (103) being electrically connected to a control pad (15),
applying a mold compound (16) that covers the inner surfaces of the first, second and third leads (18, 22, 23), the first and transistor devices (25, 26);
wherein the at least one control contact pad (15), and side faces (12, 13, 14) of the first, second and third leads (18, 22, 23) that are arranged substantially perpendicularly to the respective inner surface are arranged in a common plane (11) that is substantially perpendicular to the first major surface (28) of the first transistor device (25).
